# EUROPEAN PATENT APPLICATION

(11) **EP 4 835 608 A2**
(43) Date of publication of application: **04.11.2026**
(21) Application number: 26206179.9
(22) Date of filing: 07.12.2023
(51) Int. Cl.: G06F 1/16

(54) **FOLDABLE DISPLAY DEVICE**

(30) Priority: 22.12.2022 KR 20220181774
(62) Document number(s) of the earlier application(s) in accordance with Art. 76 EPC: 23214859.3 / 4 390 618
(71) Applicant: LG Display Co., Ltd., Seoul 07336 (KR)
(72) Inventor: Lee, GyuHo, 10845 Paju-si (KR); Choi, Suk, 10845 Paju-si (KR); Park, Sungjin, 10845 Paju-si (KR)
(74) Representative: Kilburn & Strode LLP

(57) **Abstract**

Discussed is a foldable display device. The foldable display device includes a display panel including a folding area and non-folding areas located on opposite sides of the folding area, a first support substrate disposed under the display panel to support the display panel and including a plurality of opening patterns corresponding to the folding area, a second support substrate disposed between the display panel and the first support substrate and an adhesive layer corresponding to the non-folding areas and disposed between the first support substrate and the second support substrate. At least one of the first support substrate and the second support substrate includes a protrusion located adjacent to the folding area and protruding therefrom.

## Description

### CROSS-REFERENCE TO RELATED APPLICATIONS

This application claims the priority to Korean Patent Application No. 10-2022-0181774 filed in the Republic of Korea on December 22, 2022, the entire contents of which are hereby expressly incorporated by reference into the present application.

### BACKGROUND OF THE DISLCOSURE

### Field

The present disclosure relates to a foldable display device, and more particularly, to a foldable display device with improved folding properties and impact resistance.

### Description of the Related Art

With advancement of an information-oriented society, a technical field relating to display devices that are able to visually express electric information signals on a screen has been rapidly growing. Thus, various display devices that are thin, light, and have low power consumption are being developed and improved. Examples of the various display devices can include a liquid crystal display (LCD) device, a plasma display panel (PDP) device, a field emission display (FED) device, an organic light-emitting display (OLED) device, etc.

Recently, flexible display devices to display an image even when bent or folded like paper have begun receiving attention as next-generation display devices. The flexible display devices can be classified into a display device having a high durability and resistant to breakage, and a bendable display device capable of being bent and flexible without breaking. The flexible display devices can also be classified into a rollable display device capable of being rolled, and a foldable display device capable of being folded.

Such flexible display devices have utility in space usability, interior functionality, and pleasant design and can be applied to various application fields. A display panel of the flexible display devices can use a flexible substrate. A support substrate such as a back plate is disposed under the display panel having the flexible substrate to suppress sagging of the display panel and protect the display panel against foreign matters and impact from the outside in various applications.

### SUMMARY OF THE DISCLOSURE

An objective to be achieved by the present disclosure is to provide a foldable display device with excellent or improved foldability and improved impact resistance.

Another objective to be achieved by the present disclosure is to provide a foldable display device which can suppress a dent in a folding area of a display panel caused by an opening pattern.

Objectives of the present disclosure are not limited to the above-mentioned objectives, and other objectives, which are not mentioned above, can be clearly understood by those skilled in the art from the following descriptions. An invention is defined in the appended claims.

According to an aspect of the present disclosure, the foldable display device can include a display panel including a folding area and non-folding areas located on opposite sides of the folding area. Also, the foldable display device includes a first support substrate disposed under the display panel to support the display panel and including a plurality of opening patterns corresponding to the folding area. Further, the foldable display device includes a second support substrate disposed between the display panel and the first support substrate. Furthermore, the foldable display device includes an adhesive layer corresponding to the non-folding areas and disposed between the first support substrate and the second support substrate. At least one of the first support substrate and the second support substrate includes a protrusion located adjacent to the folding area and protruding toward the adhesive layer.

Other detailed matters of the present disclosure are included in the detailed description and the drawings.

According to the present disclosure, it is possible to improve foldability of the foldable display device by maintaining an air gap within an opening pattern of a folding area.

Also, according to the present disclosure, it is possible to solve or address limitations caused by an adhesive flowing into the opening pattern of the folding area during folding of the foldable display device.

Further, according to the present disclosure, it is possible to improve durability such as impact resistance for the foldable display device.

The effects according to the present disclosure are not limited to the contents exemplified above, and various effects are included in the present specification.

### BRIEF DESCRIPTION OF THE DRAWINGS

The above and other aspects, features and other advantages of the present disclosure will be more clearly understood from the following detailed description taken in conjunction with the accompanying drawings, in which:
FIG. 1A is a schematic plan view of a foldable display device according to an embodiment of the present disclosure;
FIG. 1B is a schematic cross-sectional view as taken along a line I-I' of FIG. 1A;
FIG. 1C is a schematic plan view of a first support substrate according to an embodiment of the present disclosure;
FIG. 2A and FIG. 2B are schematic cross-sectional views of a conventional foldable display device;
FIG. 3A through FIG. 3E are schematic plan views of a first support substrate according to another embodiment of the present disclosure;
FIG. 4 is a schematic cross-sectional view of a foldable display device according to yet another embodiment of the present disclosure;
FIG. 5A is a schematic plan view of a first support substrate of a foldable display device according to still another embodiment of the present disclosure;
FIG. 5B is a schematic plan view of a second support substrate of the foldable display device according to still another embodiment of the present disclosure;
FIG. 5C is a schematic cross-sectional view showing the first support substrate of FIG. 5A coupled to the second support substrate of FIG. 5B;
FIG. 6A is a schematic cross-sectional view of a foldable display device according to another embodiment of the present disclosure;
FIG. 6B is a schematic cross-sectional view of a foldable display device according to another embodiment of the present disclosure;
FIG. 6C is a schematic cross-sectional view of a foldable display device according to another embodiment of the present disclosure; and
FIG. 6D is a schematic cross-sectional view of a foldable display device according to another embodiment of the present disclosure.

### DETAILED DESCRIPTION OF THE EMBODIMENTS

Advantages and characteristics of the present disclosure and a method of achieving the advantages and characteristics will be clear by referring to example embodiments described below in detail together with the accompanying drawings. However, the present disclosure is not limited to the example embodiments disclosed herein but will be implemented in various forms. The example embodiments are provided by way of example only so that those skilled in the art can fully understand the disclosures of the present disclosure and the scope of the present disclosure.

The shapes, sizes, ratios, angles, numbers, and the like illustrated in the accompanying drawings for describing the example embodiments of the present disclosure are merely examples, and the present disclosure is not limited thereto. Like reference numerals generally denote like elements throughout the specification. Further, in the following description of the present disclosure, a detailed explanation of known related technologies can be omitted to avoid unnecessarily obscuring the subject matter of the present disclosure. The terms such as "including," "having," and "comprising" used herein are generally intended to allow other components to be added unless the terms are used with the term "only". Any references to a singular element can include the plural of the element unless expressly stated otherwise.

Components are interpreted to include an ordinary error range even if not expressly stated.

When the position relation between two parts is described using the terms such as "on", "above", "below", and "next", one or more parts can be positioned between the two parts unless the terms are used with the term "immediately" or "directly".

When an element or layer is disposed "on" another element or layer, another layer or another element can be interposed directly on the other element or therebetween.

Although the terms "first", "second", and the like are used for describing various components, these components are not confined by these terms. These terms are merely used for distinguishing one component from the other components, and may not define order or sequence. Therefore, a first component to be mentioned below can be a second component in a technical concept of the present disclosure.

Like reference numerals generally denote like elements throughout the specification.

A size and a thickness of each component illustrated in the drawing are illustrated for convenience of description, and the present disclosure is not limited to the size and the thickness of the component illustrated.

The features of various embodiments of the present disclosure can be partially or entirely adhered to or combined with each other and can be interlocked and operated in technically various ways, and the embodiments can be carried out independently of or in association with each other.
Hereinafter, a foldable display device according to example embodiments of the present disclosure will be described in detail with reference to accompanying drawings. All the components of each foldable display device according to all embodiments of the present disclosure are operationally coupled and configured.

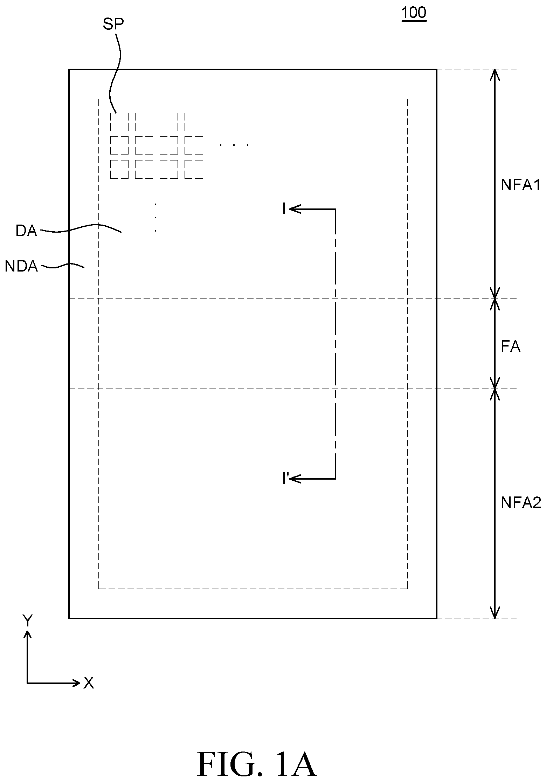

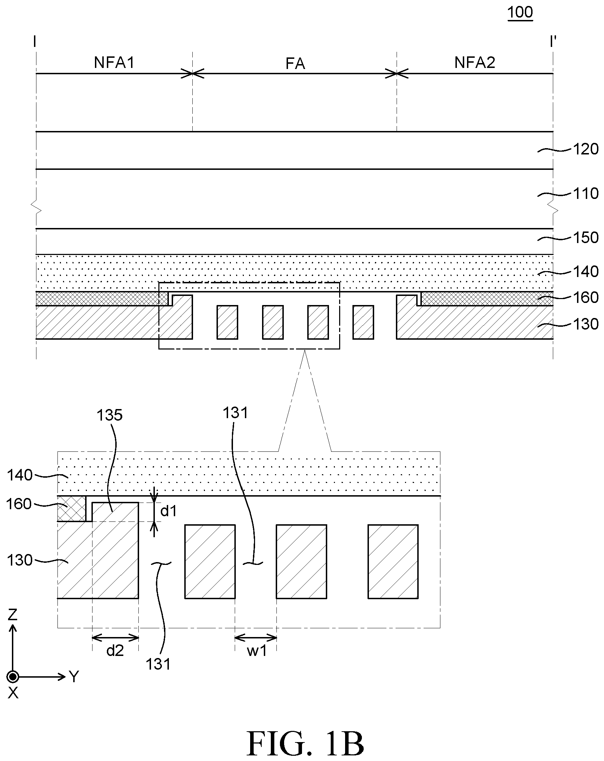

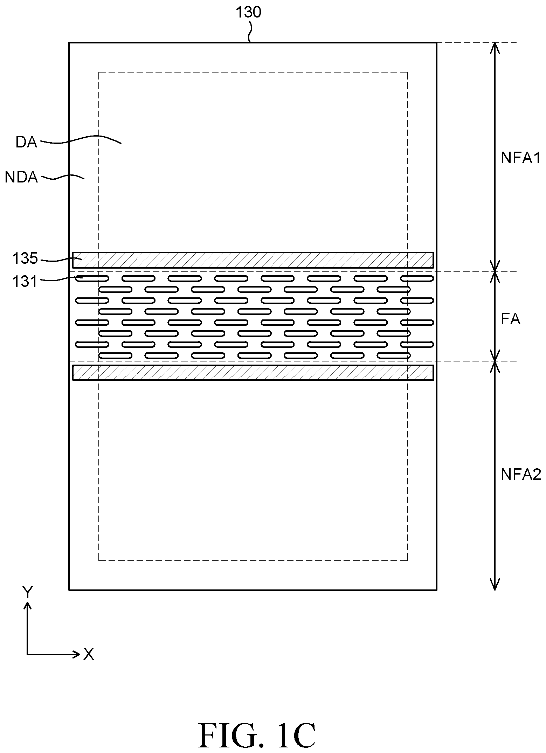

FIG. 1A is a schematic plan view of a foldable display device according to an embodiment of the present disclosure. FIG. 1B is a schematic cross-sectional view taken along a line I-I' of FIG. 1A. FIG. 1C is a schematic plan view of a first support substrate according to an embodiment of the present disclosure.

Referring to FIG. 1A and FIG. 1B, a foldable display device 100 according to an embodiment of the present disclosure includes a display panel 110, a cover window 120, and a first support substrate 130. Also, the foldable display device 100 according to an embodiment of the present disclosure includes a second support substrate 140 and a back plate 150. Hereinafter, for the convenience of description, the foldable display device 100 according to an embodiment of the present disclosure will be described as an organic light-emitting display device, but the present disclosure is not limited thereto, and other types of display devices are within the scope of the present disclosure.

The display panel 110 can include a display area DA and a non-display area NDA. Also, the display panel 110 can include a folding area FA and non-folding areas NFA1 and NFA2. The display panel 110 can be divided into the display area DA and the non-display area NDA depending on whether it can display an image. Further, the display panel 110 can be divided into the folding area FA and the non-folding areas NFA1 and NFA2 depending on whether it is foldable. Accordingly, a part of the display panel 110 can be simultaneously the display area DA and the folding area FA, and another part of the display panel 110 can be simultaneously the non-display area NDA and the non-folding areas NFA1 and NFA2.

Although described with one folding area FA and two non-folding areas NFA1 and NFA2, embodiments of the present disclosure can include a plurality of folding areas FA and three or more non-folding areas NFA that may be arranged in series, parallel, and alternatingly. For example, a non-folding area NFA can be interposed between two folding areas FAs, and such an arrangement can be provided in series, so that a series of alternating folding areas FAs and non-folding areas NFAs can be provided in the display panel 100. In other embodiments of the present disclosure, two folding areas FAs can intersect, so that a first folding area FA can extend in an X-axis direction and a second folding area FA can extend in a Y-axis direction to form a cross-shaped folding area FA that is able to fold a display panel in a vertical direction and a horizontal direction.

Hereinafter, for the convenience of description, the foldable display device 100 according to an embodiment of the present disclosure will be described as a foldable display device in which one folding area FA is disposed only in a part of the display area DA. However, the foldable display device 100 according to an embodiment of the present disclosure can also be a display device in which a plurality of folding areas are disposed in the display area DA of the display panel 110. However, the present disclosure is not limited thereto. The folding area FA and the non-folding areas NFA can also be included in the non-display area NDA.

The display area DA is an area where a plurality of pixels is disposed to substantially display an image. In the display area DA, a plurality of pixels including an emission area for displaying an image, a thin film transistor for driving the pixels, and a capacitor can be disposed. However, the present disclosure is not limited thereto, and other structures can be included. Each pixel can include a plurality of sub-pixels SP. The sub-pixel SP is a minimum unit constituting the display area, and each sub-pixel SP can be configured to emit light of a specific wavelength band relating to a color. For example, each of the sub-pixels SP can be configured to emit red light, green light, blue light, or white light. Other colors can be emitted, such as a yellow-green light or various wavelengths, such as ultraviolet light.

The non-display area NDA can be disposed adjacent the display area DA to enclose or encircle the display area DA. The non-display area NDA is an area where an image is not displayed, or not substantially displayed, and is an area in which various lines and driving ICs for driving the pixels and the driving elements disposed in the display area DA are disposed. In embodiments of the present disclosure, non-display area NDA can be disposed at a periphery of the display area DA.

As described above, the display panel 110 can also be divided into the folding area FA and non-folding areas NFA1 and NFA2 depending on whether the display panel 110 is foldable. The display panel 110 can include one folding area FA which is foldable and the non-folding areas NFA1 and NFA2 that are areas excluding the folding area FA. The folding area FA is an area which can be folded when the foldable display device 100 is folded. The folding area FA can be folded in accordance with a specific radius of curvature with respect to a folding axis. Herein, the folding axis can be formed in an X-axis direction. The non-folding areas NFA1 and NFA2 can be located on opposite sides of the folding area FA along a folding direction. Herein, the folding direction can refer to a Y-axis direction perpendicular to the folding axis. When the folding area FA is folded with respect to the folding axis, the folding area FA can form a part of a circle or an oval, and can have the specific radius of curvature. In this example, the specific radius of curvature of the folding area FA can refer to a radius of a circle or an oval formed by the folding area FA when the foldable display device 100 is folded.

The non-folding areas NFA1 and NFA2 are areas which are not folded when the foldable display device 100 is folded. For example, the non-folding areas NFA1 and NFA2 can maintain a flat state or a non-folded stated when the foldable display device 100 is folded. The non-folding areas NFA1 and NFA2 can extend from the opposite sides of the folding area FA along the folding direction. For example, the non-folding units NFA1 and NFA2 can be areas extending to the Y-axis direction with respect to the folding axis. Herein, the folding area FA can be defined between the non-folding areas NFA1 and NFA2. The non-folding areas NFA1 and NFA2 include a first non-folding area NFA1 and a second non-folding area NFA2. The first non-folding area NFA1 can extend from one side of the folding area FA, and the second non-folding area NFA2 can extend from the other side of the folding area FA. When the foldable display device 100 is folded with respect to the folding axis, the first non-folding area NFA1 and the second non-folding area NFA2 can overlap each other. The non-folding areas NFA1 and NFA 2 need not be rigid, but can be flexible, and can be bent or have a maximum radius of curvature that is equal to or less than that of the specific radius of curvature of the folding area FA. In embodiments of the present disclosure, a meaning of the non-folding areas NFA1 and NF2 can be as broad as an area that is not the folding area FA, and which corresponds to a location of the foldable display device 100 that is not folded.

The display panel 110 can include a flexible substrate, a driving thin film transistor, and a display element. In the display panel 110, the flexible substrate on which the driving thin film transistor and the display element are formed is encapsulated by an encapsulation unit. The display panel 110 can include the flexible substrate having a very small thickness or being thin and the display element disposed on the flexible substrate to implement flexibility.

The flexible substrate can support various elements constituting the display panel 110. The flexible substrate can be made of or include an insulating material having a very small thickness or being thin to implement flexibility. For example, the flexible substrate can be an insulating plastic substrate selected from polyimide, polyethersulfone, polyethylene terephthalate, and polycarbonate, but is not limited thereto. Other materials such as resin, polymer, or organic material can be used for the flexible substrate.

A plurality of driving thin film transistors can be disposed on the flexible substrate to drive the display element. One or more driving thin film transistors can be disposed in each of the plurality of sub-pixels. For example, the driving thin film transistor can include a gate electrode, an active layer, a source electrode, and a drain electrode. Further, the driving thin film transistor can include a gate insulating layer for insulating the active layer from the gate electrode. Furthermore, the driving thin film transistor can include an interlayer insulating layer for insulating the gate electrode from the source electrode and the drain electrode. However, the present disclosure is not limited thereto.

The display element can be an organic light-emitting diode. The organic light-emitting diode can include an anode, a cathode, and an organic emission layer disposed between the anode and the cathode. In the organic light-emitting diode, holes injected from the anode and electrons injected from the cathode are coupled on the organic emission layer to emit light. An image can be displayed by using the light emitted as described above. The flexible display device can include a plurality of display elements in numbers corresponding to the plurality of sub-pixels.

The cover window 120 is disposed on the display panel 110. The cover window 120 protects the display panel 110 against impact and scratches from the outside. Thus, the cover window 120 can be made of or include a material which is transparent and has excellent or improved impact resistance and scratch resistance. Also, the cover window 120 protects the display panel 110 from moisture or the like permeating from the outside. Thus, the cover window 120 can suppress degradation of the display panel 110 and a decrease in display quality.

The cover window 120 can be implemented with a malleable plastic-based cover which is foldable for thinness and flexibility of the foldable display device 100. For example, the cover window 120 can be a film made of a polymer such as polyimide, polyamide imide, polyethylene terephthalate, polymethyl methacrylate, polypropylene glycol, and polycarbonate. For another example, the cover window 120 can be a film made of a photoisotropic polymer such as cycloolefin (co)polymer, photoisotropic polycarbonate, or photoisotropic polymethyl methacrylate. Other organic materials can be used for the cover window 120.

The cover window 120 can be a multilayered structure in which various functional layers are laminated. For example, the cover window 120 can include various functional layers such as an external light reflection reducing layer, a UV blocking layer, or a hard coating layer. Also, if necessary or desired, a touch panel serving as a touch sensor can be optionally disposed between the display panel 110 and the cover window 120. Other layers can be included in the cover window 120.

Meanwhile, the flexible substrate of the display panel 110 has excellent or improved folding properties, but has a smaller thickness and lower rigidity than a glass substrate or a metal substrate. Thus, it is difficult for the flexible substrate to maintain a constant shape during folding, and sagging can occur due to various elements formed on the flexible substrate. Therefore, in order to support the flexible substrate and improve the impact resistance, the first support substrate 130, the second support substrate 140, and the back plate 150 are disposed under the display panel 110. The first support substrate 130, the second support substrate 140, and the back plate 150 under the display panel 110 can support the display panel 110 to suppress sagging or deformation. Also, the first support substrate 130, the second support substrate 140, and the back plate 150 under the display panel 110 can protect the display panel 110 against impact or foreign matters from the outside.

The first support substrate 130 can be referred to as a bottom plate. The first support substrate 130 can include a plurality of opening patterns 131 formed corresponding to the folding area FA of the foldable display device 100. An elastic deformation region of the foldable display device 100 is increased by the plurality of opening patterns 131 formed in the folding area FA. Thus, the foldable display device 100 can be folded or unfolded.

The first support substrate 130 can be made of or include a metal material such as stainless steel (SUS), SUS containing a metal such as nickel (Ni), iron (Fe), aluminum (Al), or magnesium (Mg). For example, the first support substrate 130 can be made of SUS. SUS has high restoring force and rigidity, and, thus, even if the first support substrate 130 decreases in thickness, the first support substrate 130 can maintain high rigidity. Thus, the first support substrate 130 supports the display panel 110 and also allows a decrease in overall thickness of the foldable display device 100. Therefore, it is possible to reduce the radius of curvature of the folding area FA. However, the first support substrate 130 is not limited thereto, and other materials can be used. For example, the first support substrate 130 can also be made of or include a polymer such as polymethylmetacrylate (PMMA), polycarbonate (PC), polyvinyl alcohol (PVA), acrylonitrile-butadiene-styrene (ABS), polyethylene terephthalate (PET), silicone or polyurethane (PU).

The first support substrate 130 includes a protrusion 135 which protrudes from the non-folding area NFA adjacent to the folding area FA toward the second support substrate 140. The protrusion 135 can serve as a dam for controlling the flow of an adhesive layer 160 formed in the non-folding areas NFA1 and NFA2 between the first support substrate 130 and the second support substrate 140. Thus, the protrusion 135 can suppress permeation of the adhesive layer 160 into the folding area FA. In the foldable display device 100 according to an embodiment of the present disclosure, at least one of the first support substrate 130 and the second support substrate 140 includes the protrusion 135. For example, FIG. 1A through FIG. 1C illustrate that the first support substrate 130 located on a lower side includes the protrusion 135. However, the second support substrate 140 located on an upper side can include a protrusion protruding toward the first support substrate 130. The protrusion 135 will be described in detail with reference to FIG. 1B and FIG. 1C. The protrusion 135 can have a height or thickness that is greater than a thickness of a main body of the first support substrate 130. The protrusion 135 can be present at an edge of the non-folding area NFA or at a boundary between the non-folding area NFA and the folding area FA.

The second support substrate 140 can be disposed on the first support substrate 130. The second support substrate 140 can be referred to as a top plate. The second support substrate 140 can enhance the rigidity of the display panel 110. Also, the second support substrate 140 can prevent the plurality of opening patterns 131 formed in the first support substrate 130 from being seen through the display panel 110.

Meanwhile, the second support substrate 140 is illustrated as having a thickness similar to that of the first support substrate 130, but is not limited thereto. For example, the second support substrate 140 can have a smaller thickness than the first support substrate 130. Also, the second support substrate 140 can be made of or include a metal, an elastomer, or the same material as the first support substrate 130, but is not limited thereto. The second support substrate 140 can have a greater thickness than the first support substrate 130. When the second support substrate 140 includes a metal, the metal can include aluminum (AL) or magnesium (Mg). The second support substrate 140 can be made of or include a thermoplastic resin using a polymer having a bond selected from a carbon-carbon bond, an amide bond, an imide bond, an ester bond, an ether bond, a carbonate bond, a urethane bond, a urea bond, a thioether bond, a sulfone bond, an imidazole bond, and a carbonyl bond in the main chain, but is not limited thereto. Moreover, the second support substrate 140 can also be made of or include a fiber-reinforced resin such as carbon fiber reinforced plastics (CFRP) or glass fiber reinforced plastics (GFRP), but is not limited thereto. The fiber-reinforced resin can have electromagnetic wave permeability which can improve electronic communication and touch performance, and high tensile strength and elasticity which can improve impact resistance. The fiber-reinforced resin is lighter than metal, so the fiber-reinforced resin can be effective in strengthening structures and protecting products. Furthermore, the second support substrate 140 can also be made of or include a matrix resin having a thermosetting resin mixed with a thermoplastic resin, but is not limited thereto.

The first support substrate 130 and the second support substrate 140 can be bonded to each other by the adhesive layer 160. The adhesive layer 160 can be disposed only in the non-folding areas NFA1 and NFA2 and can optionally not be disposed in the folding area FA. Therefore, it is possible to suppress a decrease in durability caused by stress transferred from the plurality of opening patterns 131 to the adhesive layer 160 during folding of the foldable display device 100. The adhesive layer 160 can be made of or include a transparent adhesive member such as an optical clear resin (OCR) or an optical clear adhesive (OCA), but is not limited thereto. An adhesive layer can also be disposed between the second support substrate 140 and the back plate 150. Further, an adhesive layer can be disposed between the back plate 150 and the display panel 110, and between the display panel 110 and the cover window 120.

The back plate 150 can be disposed between the display panel 110 and the second support substrate 140. Since the display panel 110 is formed thin, the back plate 150 can be attached to a rear surface of the display panel 110 to further support the display panel 110, or can be omitted if necessary. The back plate 150 can suppress a transfer or distortion of the display screen caused by the plurality of opening patterns 131 formed in the first support substrate 130.

The back plate 150 can be made of a polymer such as polyimide (PI), polymethylmethacrylate (PMMA), polycarbonate (PC), polyvinylalcohol (PVA), acrylonitrile-butadiene-styrene (ABS), polyethylene terephthalate (PET), silicone or polyurethane (PU). However, the back plate 150 is not limited thereto, and other organic materials, as well as various non-organic materials can be used for the back plate 150.

Hereinafter, the protrusion disposed in the first support substrate 130 will be described in detail with reference to FIG. 1B and FIG. 1C. FIG. 1C is a schematic plan view of the first support substrate 130 according to an embodiment of the present disclosure. FIG. 1C shows the first support substrate 130 when viewed from an upper surface. Herein, the upper surface refers to a surface disposed on an upper side facing the second support substrate 140 based on FIG. 1B.

Referring to FIG. 1B, the protrusion 135 is formed to protrude from the first support substrate 130 in the non-folding areas NFA1 and NFA2 adjacent to the folding area FA in an upward direction (Z-axis direction). For example, the protrusion 135 vertically protrudes from the upper surface of the first support substrate 130 toward the second support substrate 140 facing the first support substrate 130. In other words, the protrusion 135 vertically protrudes from the upper surface of the first support substrate 130 toward the adhesive layer 160. The protrusion 135 can vertically extend from an end surface of the first support substrate 130 exposed by the opening pattern 131 of the folding area FA, but is not limited thereto. For example, the protrusion 135 can be spaced apart from the opening pattern 131 at a predetermined distance toward the non-folding areas NFA1 and NFA2 and can vertically protrude.

The protrusion 135 can serve as a dam for controlling the flow of the adhesive layer 160 formed in the non-folding areas NFA1 and NFA2 between the first support substrate 130 and the second support substrate 140. Thus, the protrusion 135 can suppress flow or permeation of the adhesive layer 160 into the folding area FA. Therefore, the adhesive layer 160 is disposed inside the protrusion 135, toward the non-folding areas NFA1 and NFA2. In this example, an inner surface of the protrusion 135 can be in contact with the adhesive layer 160. But embodiments of the present disclosure is not limited thereto, and the inner surface of the protrusion 135 need be in contact with the adhesive layer 160. That is, the inner surface of the protrusion 135 can come very close to, but not be in contact with, the adhesive layer 160.

A height or thickness d1 of the protrusion 135 can be equivalent to 50% to 90% of a height or thickness of the adhesive layer 160. If the height of the protrusion 135 is equal to or greater than that of the adhesive layer 160, the first support substrate 130 and the second support substrate 140 may not be sufficiently bonded to each other. This is because of an insufficient pressure can be provided to bond the first support substrate 130 and the second support substrate 140 while the adhesive layer 160 is disposed between the first support substrate 130 and the second support substrate 140. If the height of the protrusion 135 is smaller than 50% of the height of the adhesive layer 160, the adhesive layer 160 can flow over the protrusion 135 and permeate from the non-folding areas NFA1 and NFA2 into the folding area FA during bonding. Although not equal, the height or thickness d1 of the protrusion 135 can be such that there is a small gap between the protrusion 135 and the second support substrate 140 so that the height or thickness d1 of the protrusion 135 can be equivalent up to 99% of the height or thickness of the adhesive layer 160.

A width d2 of the protrusion 135 can be similar or identical to a width w1 of the opening pattern 131 of the first support substrate 130. But such is not required, and the width d2 of the protrusion 135 can be different to the width w1 of the opening pattern 131 of the first support substrate 130. For example, the width d2 of the protrusion 135 can be equivalent to 80% to 100% of the width of the opening pattern 131. If the width of the protrusion 135 is smaller than 80% of the width w1 of the opening pattern 131, deformation can occur due to a folding stress. If the width of the protrusion 135 is greater than that of the opening pattern 131, stress non-uniformity occurs locally in the display panel 110, which can cause damage or deformation. Also, the width d2 of the protrusion 135 can be equivalent to 80% to 100% of a distance between the opening patterns 131, but is not limited thereto. For example, the width d2 of the protrusion 135 can be greater than 100% of the width w1 of the opening pattern 131, such as 150%. Also, in embodiments of the present disclosure, the width of the opening patterns 131 need not be the same, but can vary. For example, the opening pattern 131 located closer to the protrusion 135 can be narrower than the opening patterns 131 near the middle of the folding area FA. However, the present disclosure is not limited thereto, and the opening pattern 131 located closer to the protrusion 135 can be wider than the opening patterns 131 near the middle of the folding area FA.

Referring to FIG. 1C, the protrusion 135 can be disposed in the non-folding areas NFA1 and NFA2 adjacent to the folding area FA and extends long in a direction parallel to the folding axis. For example, the protrusion 135 extends long in the X-axis direction perpendicular to the folding direction, and can be linearly formed along a virtual boundary between the folding area FA and the non-folding areas NFA1 and NFA2. The protrusion 135 can be disposed to be in contact with the folding area FA, or can be spaced apart from the folding area FA at a predetermined distance and disposed in the non-folding areas NFA1 and NFA2.

The protrusion 135 crosses the display area DA and extends to the non-display area NDA on opposite sides. For example, opposite ends of the protrusion 135 can be disposed in the non-display area NDA. In this example, an X-axis directional length of the protrusion 135 can be greater than an X-axis directional length of the adhesive layer 160 disposed in the non-folding areas NFA1 and NFA2. For example, opposite ends of the protrusion 135 can further protrude in the X-axis direction than opposite ends of the adhesive layer 160. The X-axis directional length of the protrusion 135 can be greater than the X-axis directional length of the adhesive layer 160 disposed in the non-folding areas NFA1 and NFA2. Thus, it is possible to suppress an overflow of the adhesive layer 160 into the folding area FA through side surfaces at the opposite ends of the protrusion 135.

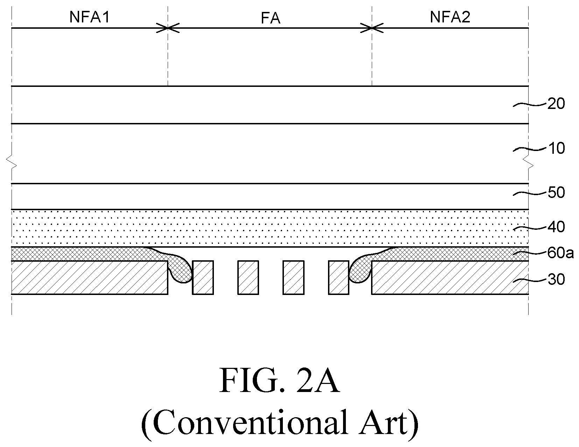

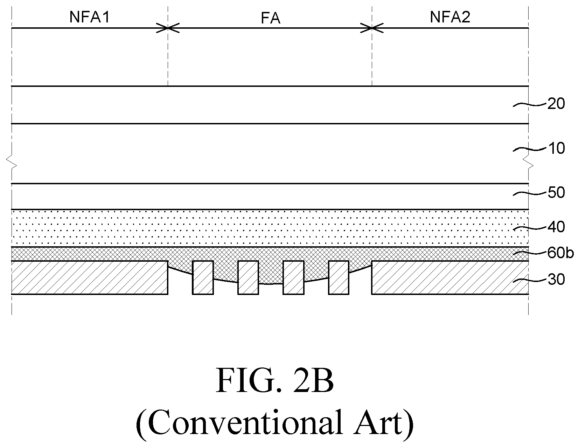

The protrusion 135 can serve as a dam for controlling the flow of the adhesive layer 160 formed in the non-folding areas NFA1 and NFA2 between the first support substrate 130 and the second support substrate 140. Thus, the protrusion 135 can suppress flow or permeation of the adhesive layer 160 into the folding area FA. The effect of the protrusion 135 formed in the first support substrate 130 on the foldable display device 100 according to an embodiment of the present disclosure will be described with further reference to FIG. 2A and FIG. 2B.

FIG. 2A and FIG. 2B are schematic cross-sectional views of a conventional foldable display device. The foldable display device shown in FIG. 2A and FIG. 2B has a structure in which a protrusion is not formed in a first support substrate, unlike the foldable display device 100 shown in FIG. 1A through FIG. 1C. FIGS. 2A and 2B also show a black plate 50, a display panel 10, and a cover window 20.

First, FIG. 2A illustrates an example where an adhesive layer 60a is disposed only in the non-folding areas NFA1 and NFA2. Specifically, when a first support substrate 30 and a second support substrate 40 are bonded to each other, the adhesive layer 60a can be located between the first support substrate 30 and the second support substrate 40. Then, a predetermined pressure is applied thereto. The adhesive layer 60a can permeate from the non-folding areas NFA1 and NFA2 into the folding area FA due to the pressure, and can permeate into the opening patterns 31 formed in the folding area FA of the first support substrate 30. Also, the adhesive layer 60a located in the non-folding areas NFA1 and NFA2 can permeate into the opening pattern 31 of the first support substrate 30 due to repeated folding of the foldable display device. If an adhesive of the adhesive layer 60a permeates into the opening pattern 31 of the first support substrate 30 as described above, the foldability of a display panel 10 can be degraded.

FIG. 2B illustrates an example where an adhesive layer 60b is disposed in all of the non-folding areas NFA1 and NFA2 and the folding area FA. In this example, the adhesive layer 60b can directly flow to or permeate into the opening pattern 31 while a pressure is applied to the first support substrate 30 and the second support substrate 40. Also, if the foldable display device is used for a predetermined time, the adhesive layer 60b located in the folding area FA can flow into the opening pattern 31 located under the adhesive layer 60b. Thus, the adhesive layer 60b can be disposed within the opening pattern 31, which can cause degradation in foldability. Further, if an air gap is not formed in the folding area FA but the adhesive layer 60b is disposed in the folding area FA, a defect can be easily generated due to a dent or a puncture during folding. Therefore, impact resistance can be degraded, and the shape of the opening pattern 31 can be transferred or projected onto the display panel 10 and can be seen.

However, in the foldable display device according to an embodiment of the present disclosure as shown in FIG. 1A through FIG. 1C, the protrusion 135 is formed to protrude from the first support substrate 130 in the non-folding areas NFA1 and NFA2 adjacent to the folding area FA toward the second support substrate 140. Thus, it is possible to suppress permeation of the adhesive layer 160 located between the first support substrate 130 and the second support substrate 140 into the folding area FA and the opening pattern 131. Accordingly, an air gap within the opening pattern 131 formed in the first support substrate 130 can be maintained, and, thus, foldability can be maintained. Also, it is possible to suppress a defect that can be caused by a dent or a puncture during folding, and can improve impact resistance and durability.

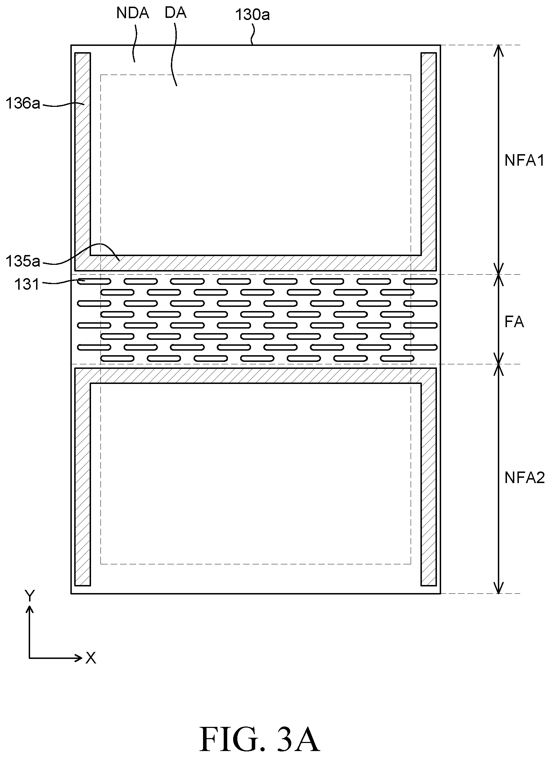

FIG. 3A through FIG. 3E are schematic plan views of a first support substrate according to another embodiment of the present disclosure. First support substrates 130a, 130b, 130c, 130d and 130e shown in FIG. 3A through FIG. 3E, respectively, are substantially the same as the first support substrate 130 shown in FIG. 1C except the structure or shape of a protrusion formed on an upper surface of a first support substrate. Therefore, a redundant description thereof will be omitted.

Referring to FIG. 3A, an auxiliary protrusion 136a can be formed on an upper surface of the first support substrate 130a. The auxiliary protrusion 136a is disposed in the non-folding areas NFA1 and NFA2 along edges of the first support substrate 130. Thus, it is possible to suppress an overflow of the adhesive layer 160 toward the edges of the first support substrate 130a during bonding. For example, the auxiliary protrusion 136a as well as a protrusion 135a can serve as a dam for suppressing an overflow of the adhesive layer 160 to the outside.

Referring to FIG. 3A, the auxiliary protrusion 136a can be disposed in the non-folding areas NFA1 and NFA2 adjacent to outer peripheral portions of the first support substrate 130a. The auxiliary protrusion 136a can be disposed in the non-display area NDA adjacent to the outer peripheral portions of the first support substrate 130a and corresponding to the non-folding areas NFA1 and NFA2. For example, the auxiliary protrusion 136a can extend long in the Y-axis direction along the outer peripheral portions of the first support substrate 130a or the non-folding areas NFA1 and NFA2. Also, the auxiliary protrusion 136a can be linearly formed along the edges of the first support substrate 130a. The auxiliary protrusion 136a can be spaced apart from the edges of the first support substrate 130a at a predetermined distance and disposed in the non-folding areas NFA1 and NFA2.

FIG. 3A illustrates the auxiliary protrusion 136a located on opposite sides in the X-axis direction and extending long in the Y-axis direction. However, a structure located on opposite sides in the Y-axis direction and extending long in the X-axis direction can be further provided, for example, along a top edge and a bottom edge of the first support structure 130a.

Referring to FIG. 3A, the auxiliary protrusion 136a can be connected to the protrusion 135a. Specifically, the auxiliary protrusion 136a can be connected to the protrusion 135a in the non-display area NDA adjacent to the folding area FA. Since the auxiliary protrusion 136a is connected to the protrusion 135a, an accommodation space where the adhesive layer 160 is located can be formed inside the auxiliary protrusion 136a and the protrusion 135a. Accordingly, the auxiliary protrusion 136a and the protrusion 135a can enclose the adhesive layer 160 and thus suppress an overflow or exposure of the adhesive layer 160 to the outside of the folding area FA and the display panel 110.

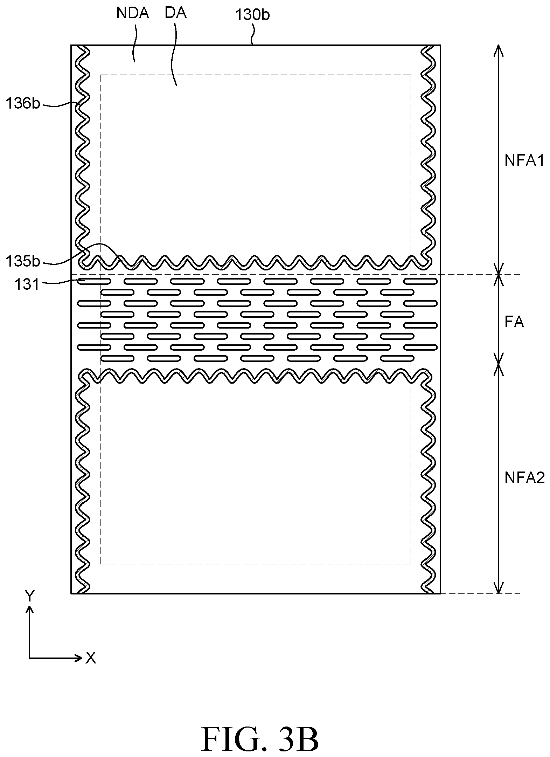

Referring to FIG. 3B, a protrusion 135b and/or an auxiliary protrusion 136b disposed on the first support substrate 130b can have a plurality of bends, such as curves. Each of the protrusion 135a and the auxiliary protrusion 136a shown in FIG. 3A is linearly formed along the edges of the folding area FA and the first support substrate 130a on the first support substrate 130a. However, the protrusion 135b and the auxiliary protrusion 136b shown in FIG. 3B can have a plurality of inner bends and a plurality of outer bends, respectively, in a serpentine pattern. For example, the protrusion 135b and the auxiliary protrusion 136b can have bends extending in one direction.

If the protrusion 135b and the auxiliary protrusion 136b have a plurality of bends, a space where the adhesive layer 160 is further accommodated can be formed in each bend. Accordingly, the adhesive layer 160 can be pushed to outer peripheral portions of the folding area FA and the first support substrate 130 while the first support substrate 130b and the second support substrate 140 are bonded to each other. In this example, the bends can accommodate the adhesive layer 160 and thus suppress an overflow of the adhesive layer 160 to upper surfaces of the protrusion 135b and the auxiliary protrusion 136b.

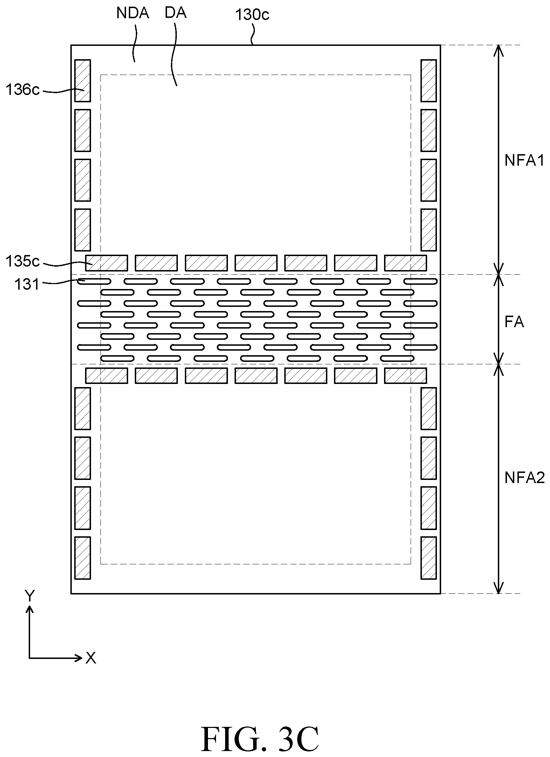

Referring to FIG. 3C, a plurality of protrusions 135c and/or a plurality of auxiliary protrusions 136c can be formed on the first support substrate 130c. For example, in the foldable display device 100 according to an embodiment of the present disclosure, the protrusion 135c can be disposed on the first support substrate 130c. In this example, a plurality of protrusions 135c can be disposed to form a pattern. Also, as shown in FIG. 3A, if the auxiliary protrusion 136c is disposed on the first support substrate 130c in addition to the protrusion 135c, at least one of the protrusion 135c and the auxiliary protrusion 136c can be plural in number. FIG. 3C illustrates a plurality of protrusions 135c and a plurality of auxiliary protrusions 136c. Hereinafter, a description will be made focusing on the protrusions 135c.

Specifically, the plurality of protrusions 135c can be spaced apart from each other along the folding area FA and disposed in the non-folding areas NFA1 and NFA2 adjacent to the folding area FA. For example, the plurality of protrusions 135c can be spaced apart from the folding area FA at a predetermined distance along the direction parallel to the folding axis. In this example, each of the protrusions 135c can have a bar shape extending in the X-axis direction or can have a hexahedral shape. However, the present disclosure is not limited thereto, and other shapes are possible.

A separation distance between the protrusions 135c can be adjusted in order for the adhesive layer 160 not to flow between the protrusions 135c or not to be deformed in consideration of cohesion of the adhesive layer 160.

Also, the plurality of protrusions 135c need not overlap each other, and can be disposed in a zigzag pattern along edges of the non-display area NDA. If the plurality of protrusions 135c is spaced apart from each other in a zigzag pattern along the direction parallel to the folding axis, the flowability of the adhesive layer 160 can be controlled more effectively.

Meanwhile, FIG. 3C illustrates that each of the plurality of protrusions 135c has a bar shape or a hexahedral shape. However, the present disclosure is not limited thereto. Each of the plurality of protrusions 135c can have various shapes capable of controlling the flowability of the adhesive layer 160. For example, each of the plurality of protrusions 135c can have a rectangular shape such as a trapezoid shape or an inverted trapezoid shape, or can have a polygonal shape having a plurality of faces with respect to a cross-section. For another example, each of the plurality of protrusions 135c can have at least one curved surface or can have a partially circular shape, or shapes having multiple waves or curves.

Meanwhile, FIG. 3C illustrates that the plurality of protrusions 135c has the same shape. However, at least some or all of the protrusions 135c can have different shapes from each other. Also, the protrusions 135c can have different heights from each other.

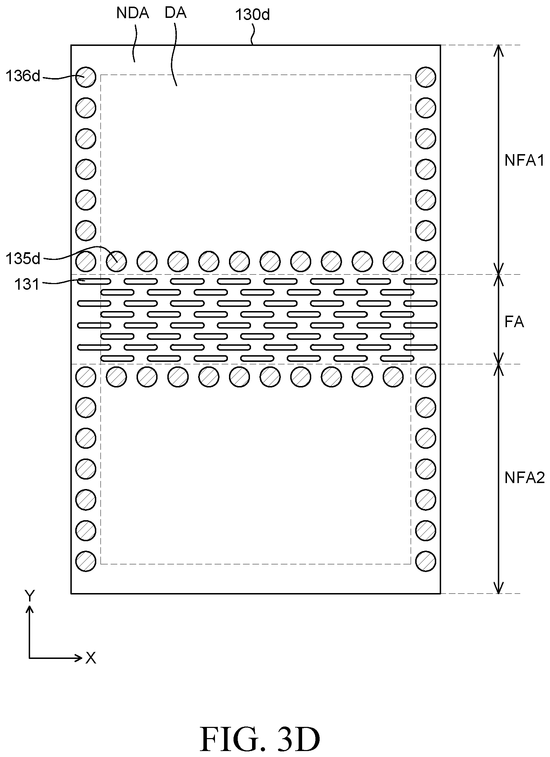

Referring to FIG. 3D, each of a plurality of protrusions 135d and/or a plurality of auxiliary protrusions 136d disposed on the first support substrate 130d can have a cylindrical shape, which is different from each of the plurality of protrusions 135c and the plurality of auxiliary protrusions 136c on the first support substrate 130c shown in FIG. 3C having a hexahedral shape..

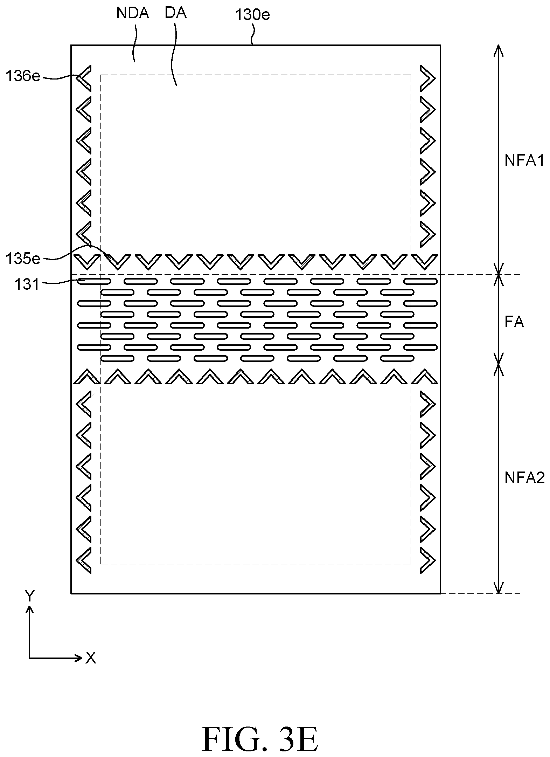

Referring to FIG. 3E, each of a plurality of protrusions 135e and/or a plurality of auxiliary protrusions 136e disposed on the first support substrate 130e can have a bent shape. Each of the plurality of protrusions 135c and the plurality of auxiliary protrusions 136c on the first support substrate 130c shown in FIG. 3C has a hexahedral shape. However, each of the plurality of protrusions 135e and the plurality of auxiliary protrusions 136e shown in FIG. 3E can be bent toward the non-folding areas NFA1 and NFA2 and can have an arrowhead (>) shape or a chevron shape. Also, each of the plurality of protrusions 135e can have a bend, and ends of each protrusion 135e can be directed towards the non-folding areas NFA1 and NFA2, respectively.

If each of the plurality of protrusions 135e and the plurality of auxiliary protrusions 136e has a bent shape, a space where the adhesive layer 160 is further accommodated can be formed in each bend toward the non-folding areas NFA1 and NFA2, and be opened towards the non-folding areas NFA1 and NFA2. Accordingly, the adhesive layer 160 can be pushed to the outer peripheral portions of the folding area FA and the first support substrate 130 while the first support substrate 130e and the second support substrate 140 are bonded to each other. In this example, the bends can accommodate the adhesive layer 160 and thus suppress an overflow of the adhesive layer 160 to upper surfaces of the protrusions 135e and the auxiliary protrusions 136e. Also, the bent shape can control the flowability of the adhesive layer 160.

Meanwhile, FIG. 3A through FIG. 3E illustrate that each protrusion has the same shape as each auxiliary protrusion. However, each protrusion can have a different shape from each auxiliary protrusion. For example, a protrusion can be formed into a straight line extending long in the X-axis direction and a plurality of auxiliary protrusions can be formed. For another example, a plurality of protrusion each having a bar shape can be formed and an auxiliary protrusion can be formed into a straight line extending long in the X-axis direction. For yet another example, a plurality of protrusions each having a bar shape and a plurality of auxiliary protrusions each having a cylindrical shape can be formed.

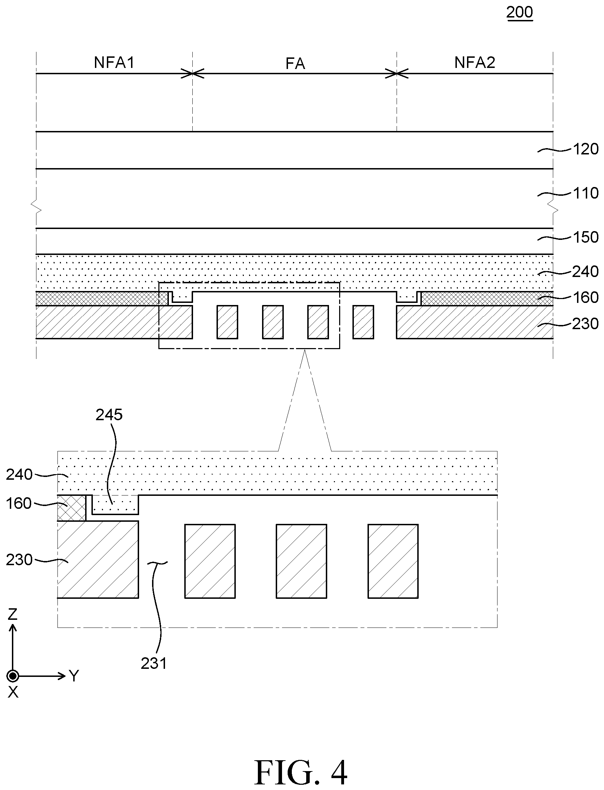

FIG. 4 is a schematic cross-sectional view of a foldable display device according to yet another embodiment of the present disclosure. Referring to FIG. 4, a foldable display device 200 according to yet another embodiment of the present disclosure includes a first support substrate 230, a plurality of opening patterns 231, a second support substrate 240, and the adhesive layer 160. The foldable display device 200 shown in FIG. 4 is substantially the same as the foldable display device 100 shown in FIG. 1B expect that a protrusion 245 is formed on the second support substrate 240. Therefore, a redundant description thereof will be omitted.

In the foldable display device 200 according to yet another embodiment of the present disclosure, the second support substrate 240 includes the protrusion 245 protruding toward the first support substrate 230 in the non-folding areas NFA1 and NFA2 adjacent to the folding area FA. The protrusion 245 can serve as a dam for controlling the flow of the adhesive layer 160 formed in the non-folding areas NFA1 and NFA2 between the first support substrate 230 and the second support substrate 240. Thus, the protrusion 245 suppresses permeation of the adhesive layer 160 into the folding area FA.

Referring to FIG. 4, the protrusion 245 is formed to protrude from the second support substrate 240 in the non-folding areas NFA1 and NFA2 adjacent to the folding area FA in a downward direction (Z-axis direction). For example, the protrusion 245 vertically protrudes from a lower surface of the second support substrate 240 toward the first support substrate 230 facing the second support substrate 240. In other words, the protrusion 245 vertically protrudes from the lower surface of the second support substrate 240 toward the adhesive layer 160.

A lower surface of the protrusion 245 can be spaced part from an upper surface of the first support substrate 230. The lower surface of the protrusion 245 can be formed to be in contact with the first support substrate 230. In this example, it can be difficult to apply a sufficient bonding pressure to the adhesive layer 160 while the first support substrate 230 and the second support substrate 240 are bonded to each other.

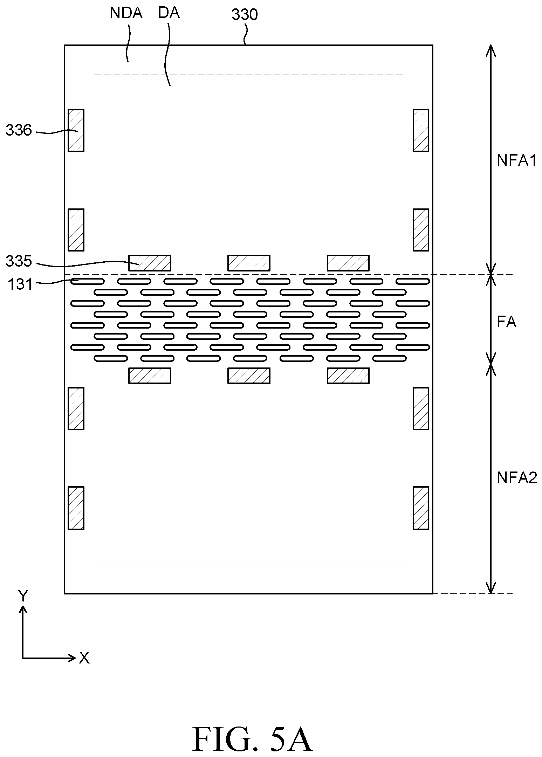

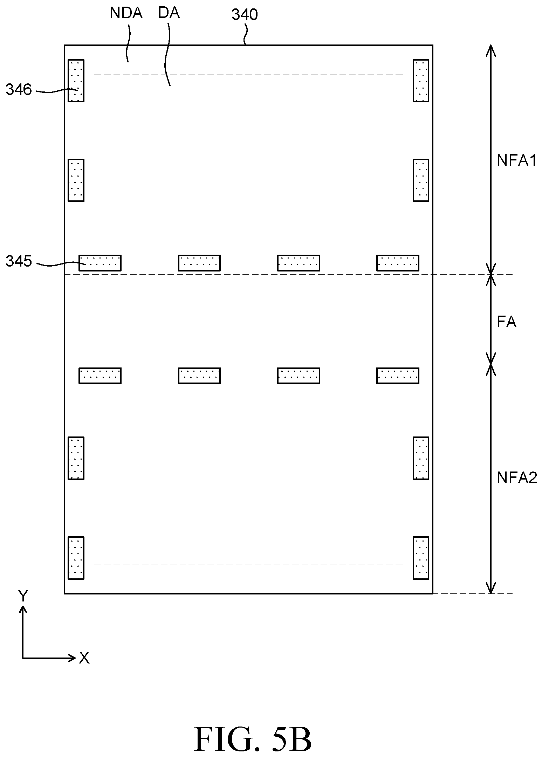

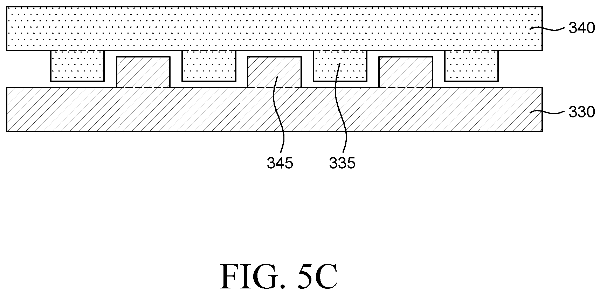

FIG. 5A through FIG. 5C illustrate a foldable display device according to still another embodiment of the present disclosure. Specifically, FIG. 5A is a schematic plan view of a first support substrate of the foldable display device according to still another embodiment of the present disclosure. FIG. 5B is a schematic plan view of a second support substrate of the foldable display device according to still another embodiment of the present disclosure. FIG. 5C is a schematic cross-sectional view showing the first support substrate of FIG. 5A coupled to the second support substrate of FIG. 5B.

Referring to FIG. 5A through FIG. 5C, the foldable display device according to still another embodiment of the present disclosure includes a first support substrate 330, a second support substrate 340, and the adhesive layer 160. The foldable display device shown in FIG. 5A through FIG. 5C is substantially the same as the foldable display device 100 shown in FIG. 1A through FIG. 1C expect that a plurality of protrusions 335 and 345 is formed on both the first support substrate 330 and the second support substrate 340. Therefore, a redundant description thereof will be omitted.

In the foldable display device according to still another embodiment of the present disclosure, the first support substrate 330 includes a plurality of first protrusions 335 and a plurality of first auxiliary protrusions 336. Also, the second support substrate 340 includes a plurality of second protrusions 345 and a plurality of second auxiliary protrusions 346.

Referring to FIG. 5A, the plurality of first protrusions 335 can be spaced apart from each other along the folding area FA and disposed in the non-folding areas NFA1 and NFA2 adjacent to the folding area FA. For example, the plurality of first protrusions 335 can be spaced apart from the folding area FA at a predetermined distance along the direction parallel to the folding axis. Also, the plurality of first auxiliary protrusions 336 is spaced apart from edges of the first support substrate 330 and disposed in the non-folding areas NFA1 and NFA2. The plurality of first auxiliary protrusions 336 can be disposed in the Y-axis direction along the edges of the first support substrate 330 or the non-folding areas NFA1 and NFA2. In this example, each of the second protrusions 345 can have a bar shape extending in the X-axis direction, and each of the second auxiliary protrusions 346 can have a bar shape extending in the Y-axis direction.

Referring to FIG. 5B, the plurality of second protrusions 345 can be spaced apart from each other along the folding area FA and disposed in the non-folding areas NFA1 and NFA2 adjacent to the folding area FA. For example, the plurality of second protrusions 345 can be spaced apart from the folding area FA at a predetermined distance along the direction parallel to the folding axis. Also, the plurality of second auxiliary protrusions 346 is spaced apart from edges of the second support substrate 340 and disposed in the non-folding areas NFA1 and NFA2. The plurality of second auxiliary protrusions 346 can be disposed in the Y-axis direction along the edges of the second support substrate 340 or the non-folding areas NFA1 and NFA2. In this example, each of the second protrusions 345 can have a bar shape extending in the X-axis direction, and each of the second auxiliary protrusions 346 can have a bar shape extending in the Y-axis direction.

Meanwhile, the plurality of first protrusions 335 disposed on the first support substrate 330 is disposed to cross the plurality of second protrusions 345 disposed on the second support substrate 340. Likewise, the plurality of first auxiliary protrusions 336 disposed on the first support substrate 330 can be disposed to cross the plurality of second auxiliary protrusions 346 disposed on the second support substrate 340. Accordingly, when the first support substrate 330 and the second support substrate 340 are bonded to each other, the first protrusions 335 can be disposed alternately with the second protrusions 345.

More specifically, referring to FIG. 5C, the plurality of first protrusions 335 formed on the first support substrate 330 and protruding upwards can be disposed alternately with the plurality of second protrusions 345 formed on the second support substrate 340 and protruding downwards. Thus, the plurality of first protrusions 335 and the plurality of second protrusions 345 can be disposed like a pair of toothed wheels. Therefore, a separation distance between the plurality of first protrusions 335 can be greater than an X-axis directional length of the second protrusion 345. Also, a separation distance between the plurality of second protrusions 345 can be greater than an X-axis directional length of the first protrusion 335.

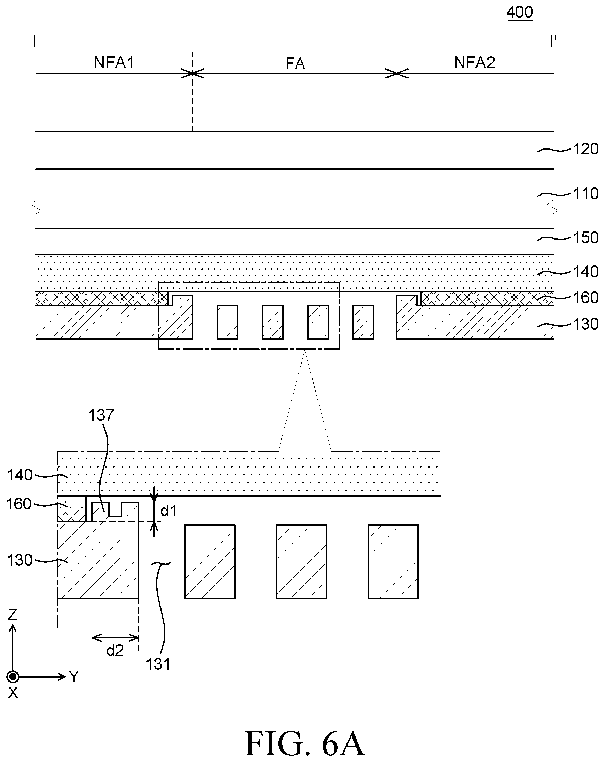

FIG. 6A is a schematic cross-sectional view of a foldable display device according to yet another embodiment of the present disclosure. Components of a foldable display device 400 illustrated in FIG. 6A are substantially identical to those of the foldable display device 100 illustrated in FIG. 1B, except for elements of the first support substrate 130. Accordingly, redundant descriptions of the same components will be omitted or may be briefly provided.

Referring to FIG. 6A, the first support substrate 130 includes a protrusion 137 which protrudes from the non-folding area NFA adjacent to the folding area FA toward the second support substrate 140. The protrusion 137 can serves as a dam for controlling the flow of an adhesive layer 160 formed in the non-folding areas NFA1 and NFA2 between the first support substrate 130 and the second support substrate 140. In this context, the protrusion 137 can have at least two sub-protrusions having a height d1, and a recess disposed between the two sub-protrusions. The two sub-protrusions are able to function as dams for controlling flow of the adhesive from the non-folding areas NFA1 and NFA2 into the folding area FA, and the recess is able to function as a reservoir to hold excess amount of adhesive layer 160 that can overtop one of the two sub-protrusions that is closer to the adhesive layer 160. In various embodiments of the present disclosure, a plurality of sub-protrusions and a plurality of recesses can be provided. However, the present disclosure is not limited thereto.

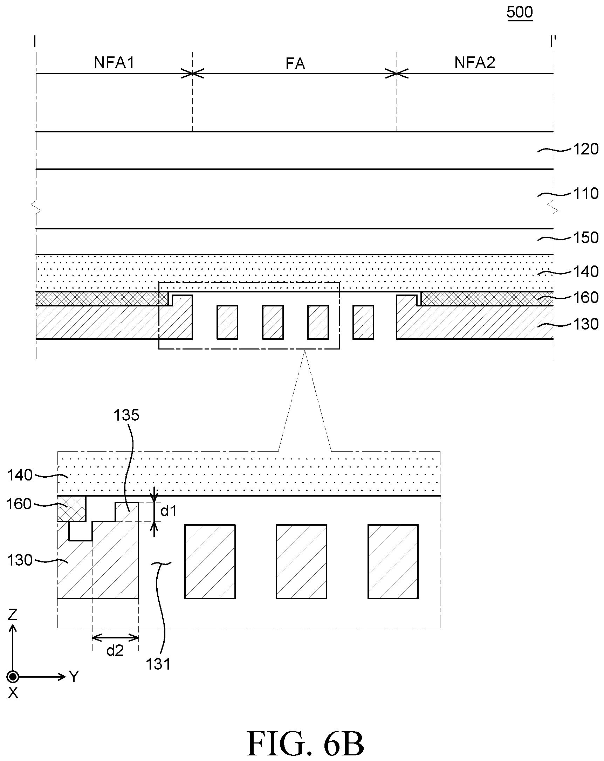

FIG. 6B is a schematic cross-sectional view of a foldable display device according to yet another embodiment of the present disclosure. Components of a foldable display device 500 illustrated in FIG. 6B are substantially identical to those of the foldable display device 100 illustrated in FIG. 1B, except for elements of the first support substrate 130. Accordingly, redundant descriptions of the same components will be omitted or may be briefly provided.

Referring to FIG. 6B, the first support substrate 130 includes a protrusion 135 which protrudes from the non-folding area NFA adjacent to the folding area FA toward the second support substrate 140. Also, the first support substrate 130 can have a recess in a main portion of the first support substrate 130 adjacent to the protrusion 135. In this embodiment of the present disclosure, the recess is not provided in the protrusion 135, but at the main portion of the first support substrate 130. Accordingly, the protrusion 135 can serves as a dam for controlling the flow of an adhesive layer 160 formed in the non-folding areas NFA1 and NFA2 between the first support substrate 130 and the second support substrate 140, and the recess in the main portion of the first support substrate 130 can function as a reservoir to hold excess amount of adhesive layer 160 before the adhesive layer 160 is able to overtop the protrusion 135. In various embodiments of the present disclosure, the protrusion 135 can have a notch that communicates with the recess in the main portion of the first support substrate to provide an additional reservoir for any excess amount of the adhesive layer 160.

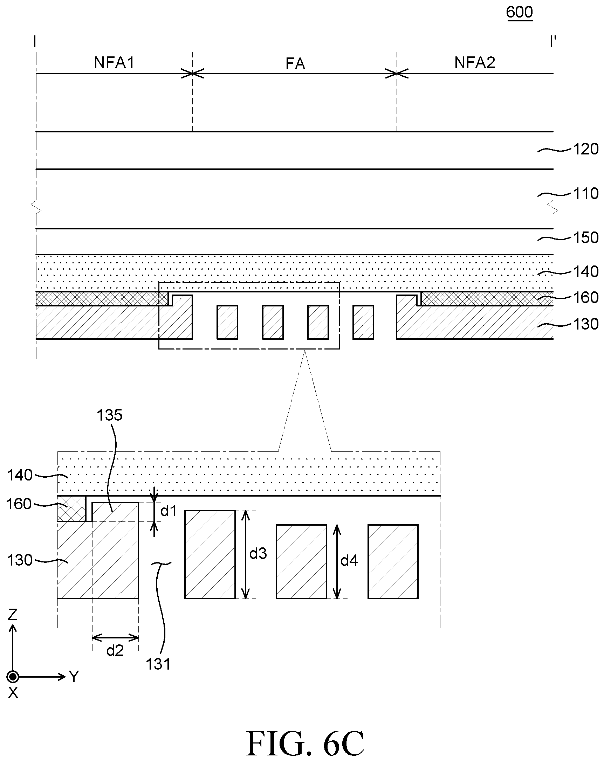

FIG. 6C is a schematic cross-sectional view of a foldable display device according to yet another embodiment of the present disclosure. Components of a foldable display device 600 illustrated in FIG. 6C are substantially identical to those of the foldable display device 100 illustrated in FIG. 1B, except for elements of the first support substrate 130. Accordingly, redundant descriptions of the same components will be omitted or may be briefly provided.

Referring to FIG. 6C, the first support substrate 130 includes a protrusion 135 which protrudes from the non-folding area NFA adjacent to the folding area FA toward the second support substrate 140. Also, the first support substrate 130 can have a plurality of opening patterns 131 defined by a plurality of sections of the first support substrate 130 located at the folding area FA.

Meanwhile, the non-folding areas NFA1 and NFA2 adjacent to the folding area FA can have greater folding stress than other surrounding areas during folding, which can cause deformation of components including the display panel. For example, as the protrusion 135 formed in the first support substrate 130, a tension in a closer section of the plurality of sections of the first support substrate 130 increases due to the difference in thickness between the protrusion 135 and the folding area FA, so a product deformation may occur. Referring to FIG. 6C, when the height or thickness d3 of the closer section is greater than the height or thickness d4 of a farther section of the plurality of sections of the first support substrate 130, the rigidity of the first support substrate 130 in the closer section and the thickness deviation between the protrusion 135 and the first support substrate 130 in the folding area can be reduced, such that deformation of other components can be reduced. However, the present disclosure is not limited thereto, and in other embodiments of the present disclosure, the another sections among the plurality sections of the first support substrate 130 can also have a different or a greater thickness, such as the thickness d3.

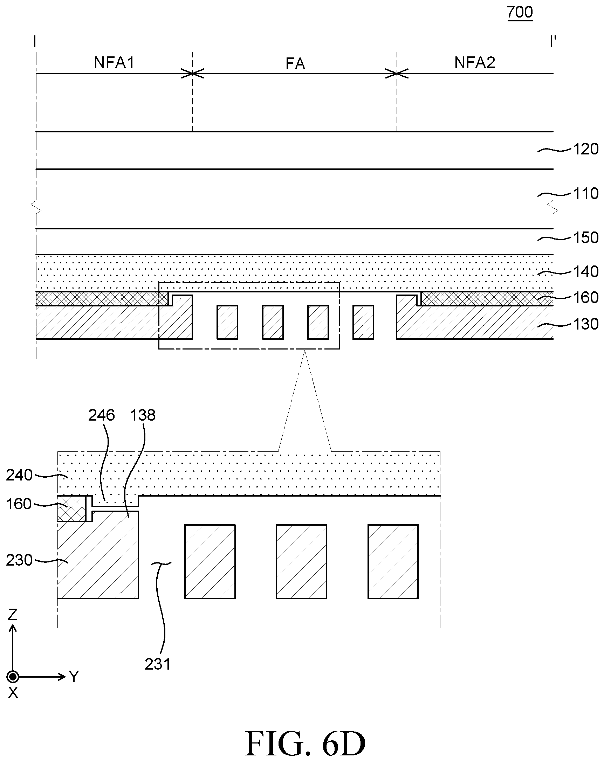

FIG. 6D is a schematic cross-sectional view of a foldable display device according to yet another embodiment of the present disclosure. Components of a foldable display device 700 illustrated in FIG. 6D are substantially identical to those of the foldable display device 100 illustrated in FIG. 1B and the foldable display device 200 illustrated in FIG. 4, except protrusions 138 and 246. Accordingly, redundant descriptions of the same components will be omitted or may be briefly provided.

Referring to FIG, 6D, the protrusion 138 provided at the first support substrate 130 and the protrusion 246 provided at the second support substrate 140 can overlap. The protrusion 138 extends from the first support substrate 130 towards the protrusion 246, and the protrusion 246 extends from the second support substrate 140 towards the protrusion 138. Accordingly, each of the protrusions 138 and the protrusion 246 have a height or thickness, and a small gap can be provided therebetween. However, the present disclosure is not limited thereto, and the small gap can be very small or there can be not a gap so that the protrusions 138 and the protrusion 246 can make contact in other embodiments of the present disclosure.

In various embodiments of the present disclosure, each of the protrusions 138 and the protrusion 246 can include at least one of a recess and a sub-protrusion that can be aligned or offset from each other. However, the present disclosure is not limited thereto.

The example embodiments of the present disclosure can also be described as follows:
According to an aspect of the present disclosure, there is provided a foldable display device. The foldable display device comprises a display panel including a folding area and non-folding areas located on opposite sides of the folding area; a first support substrate disposed under the display panel to support the display panel and including a plurality of opening patterns corresponding to the folding area; a second support substrate disposed between the display panel and the first support substrate; and an adhesive layer corresponding to the non-folding areas and disposed between the first support substrate and the second support substrate. At least one of the first support substrate and the second support substrate includes a protrusion located adjacent to the folding area and protruding toward the adhesive layer.

An inner surface of the protrusion toward the non-folding area can be in contact with the adhesive layer.

A width of the protrusion can be equal to a width of the opening pattern.

A height of the protrusion can be equivalent to 50% to 90% of a height of the adhesive layer.

The protrusion can extend long in a direction parallel to a folding axis.

The protrusion can extend in a direction parallel to a folding axis of the foldable display device.

The protrusion can have a straight line shape extending spaced apart from the folding area at a predetermined distance or a plurality of bending shapes.

The protrusion can be composed of a plurality of protrusions, and the plurality of protrusions can be spaced apart from the folding area at a first predetermined distance along a direction parallel to a folding axis of the foldable display device.

The plurality of protrusions can be spaced apart from each other at a second predetermined distance and each can have a hexahedral shape or a cylindrical shape.

Each of the plurality of protrusions can be bent toward the non-folding areas.

At least one of the first support substrate and the second support substrate further can include an auxiliary protrusion located adjacent to outer peripheral portions of the non-folding areas and protruding toward the adhesive layer.

The display panel can include a display area and a non-display area enclosing the display area, and the auxiliary protrusion can be connected to the protrusion in the non-display area adjacent to the folding area and can enclose at least a part of a side surface of the adhesive layer.

The protrusion can include a plurality of first protrusions disposed on the first support substrate and protruding toward the second support substrate, and a plurality of second protrusions disposed on the second support substrate and protruding toward the first support substrate.

The plurality of first protrusions can be disposed alternately with the plurality of second protrusions along a direction parallel to a folding axis of foldable display device.

Although the example embodiments of the present disclosure have been described in detail with reference to the accompanying drawings, the present disclosure is not limited thereto and can be embodied in many different forms without departing from the technical concept of the present disclosure. Therefore, the example embodiments of the present disclosure are provided for illustrative purposes only but not intended to limit the technical concept of the present disclosure. The scope of the technical concept of the present disclosure is not limited thereto. Therefore, it should be understood that the above-described example embodiments are illustrative in all aspects and do not limit the present disclosure. The protective scope of the present disclosure should be construed based on the following claims, and all the technical concepts in the equivalent scope thereof should be construed as falling within the scope of the present disclosure. Also disclosed herein are examples according to the following numbered clauses.
Clause 1. A foldable display device, comprising:
   a display panel including a folding area and non-folding areas located on opposite sides of the folding area;
   a first support substrate disposed under the display panel to support the display panel, and including a plurality of opening patterns corresponding to the folding area;
   a second support substrate disposed between the display panel and the first support substrate; and
   an adhesive layer corresponding to the non-folding areas and disposed between the first support substrate and the second support substrate,
   wherein at least one of the first support substrate and the second support substrate includes a protrusion located adjacent to the folding area and protruding therefrom.
Clause 2. The foldable display device according to clause 1, wherein a width of the protrusion is approximately 80% to 150% of a width of an opening pattern of the plurality of opening patterns.
Clause 3. The foldable display device according to clause 1 or clause 2, wherein a gap is present between the protrusion and one of the first support substrate and the second support substrate.
Clause 4. The foldable display device according to any preceding clause, wherein the protrusion extends in a direction parallel to a folding axis of the foldable display device.
Clause 5. The foldable display device according to clause 4, wherein the protrusion has a straight line shape extending spaced apart from the folding area at a predetermined distance or has a plurality of bending shapes.
Clause 6. The foldable display device according to any preceding clause, further comprising a plurality of protrusion including the protrusion,
   wherein the plurality of protrusions are spaced apart from the folding area at a first predetermined distance along a direction parallel to a folding axis of the foldable display device.
Clause 7. The foldable display device according to clause 6, wherein the plurality of protrusions are spaced apart from each other at a second predetermined distance, and each protrusion has a hexahedral shape or a cylindrical shape.
Clause 8. The foldable display device according to clause 6 or clause 7, wherein each of the plurality of protrusions has a bend, and ends of each protrusion are directed toward the non-folding areas, respectively.
Clause 9. The foldable display device according to any preceding clause, wherein the at least one of the first support substrate and the second support substrate further includes an auxiliary protrusion located adjacent to outer peripheral portions of the non-folding areas and protruding therefrom.
Clause 10. The foldable display device according to clause 9, wherein the display panel includes a display area and a non-display area adjacent the display area, and
   wherein the auxiliary protrusion is in the non-display area adjacent to the folding area and encloses at least a part of a side surface of the adhesive layer.
Clause 11. The foldable display device according to any preceding clause, further comprising a plurality of protrusions including the protrusion,
   wherein the plurality of protrusions include a plurality of first protrusions disposed on the first support substrate and protruding toward the second support substrate, and a plurality of second protrusions disposed on the second support substrate and protruding toward the first support substrate.
Clause 12. The foldable display device according to clause 11, wherein the plurality of first protrusions are disposed alternately with the plurality of second protrusions along a direction parallel to a folding axis of the foldable display device.
Clause 13. A foldable display device, comprising:
   a display panel including at least one folding area and at least two non-folding areas located on opposite sides of the at least one folding area;
   a first support substrate on one side of the display panel to support the display panel, and including a first area corresponding to the at least one folding area and second areas corresponding to the at least two non-folding areas;
   a second support substrate between the display panel and the first support substrate; and
   an adhesive layer disposed between the first support substrate and the second support substrate,
   wherein at least one of the first support substrate and the second support substrate includes thickness changes at portions of edges of the at least two non-folding areas and edges of the at least one folding area.
Clause 14. The foldable display device of clause 13, wherein a thickness of portions of the first support substrate in the at least one folding area is less than that of the first support substrate in the at least two non-folding areas.
Clause 15. The foldable display device of clause 13 or clause 14, wherein a thickness of a first portion of the first support substrate at the edges of the at least two non-folding area is greater than that of a second portion of the first support substrate in the at least two non-folding areas.
Clause 16. The foldable display device according to any of clauses 13 to 15, wherein a thickness of a first portion of the second support substrate at the edges of the at least two non-folding areas is greater than that of a second portion of the second support substrate in the at least two non-folding areas.
Clause 17. The foldable display device according to any of clauses 13 to 16, wherein thicknesses of first portions of the first and second support substrates at the edges of the at least two non-folding areas are greater than that of second portions of the first and second support substrates in the at least two non-folding areas, respectively.
Clause 18. The foldable display device according to any of clauses 13 to 17, wherein the thickness changes include a protrusion in at least one of the first support substrate and the second support substrate. and
   wherein a height of the protrusion in at least one of the first support substrate and the second support substrate varies along a width of the protrusion.
Clause 19. The foldable display device according to any of clauses 13 to 18, wherein the thickness changes include a recess in at least one of the first support substrate and the second support substrate.
Clause 20. The foldable display device according to any of clauses 13 to 19, wherein the thickness changes include differences in heights in portions of the first support substrate located between a plurality of opening patterns and located at the at least one folding area.
The disclosure comprises the following items:
1. A foldable display device, comprising:
   a display panel including a folding area and non-folding areas located on opposite sides of the folding area;
   a first support substrate disposed under the display panel to support the display panel, and including a plurality of opening patterns corresponding to the folding area;
   a second support substrate disposed between the display panel and the first support substrate; and
   an adhesive layer corresponding to the non-folding areas and disposed between the first support substrate and the second support substrate,
   wherein at least one of the first support substrate and the second support substrate includes a protrusion located adjacent to the folding area and protruding therefrom.
2. The foldable display device according to item 1, wherein a width of the protrusion is approximately 80% to 150% of a width of an opening pattern of the plurality of opening patterns.
3. The foldable display device according to item 1 or item 2, wherein a gap is present between the protrusion and one of the first support substrate and the second support substrate.
4. The foldable display device according to any preceding item, wherein the protrusion extends in a direction parallel to a folding axis of the foldable display device.
5. The foldable display device according to item 4, wherein the protrusion has a straight line shape extending spaced apart from the folding area at a predetermined distance or has a plurality of bending shapes.
6. The foldable display device according to any preceding item, further comprising a plurality of protrusion including the protrusion,
   wherein the plurality of protrusions are spaced apart from the folding area at a first predetermined distance along a direction parallel to a folding axis of the foldable display device.
7. The foldable display device according to item 6, wherein the plurality of protrusions are spaced apart from each other at a second predetermined distance, and each protrusion has a hexahedral shape or a cylindrical shape.
8. The foldable display device according to item 6, wherein each of the plurality of protrusions has a bend, and ends of each protrusion are directed toward the non-folding areas, respectively.
9. The foldable display device according to any preceding item, wherein the at least one of the first support substrate and the second support substrate further includes an auxiliary protrusion located adjacent to outer peripheral portions of the non-folding areas and protruding therefrom.
10. The foldable display device according to item 9, wherein the display panel includes a display area and a non-display area adjacent the display area, and
   wherein the auxiliary protrusion is in the non-display area adjacent to the folding area and encloses at least a part of a side surface of the adhesive layer.
11. The foldable display device according to any preceding item, further comprising a plurality of protrusions including the protrusion,
   wherein the plurality of protrusions include a plurality of first protrusions disposed on the first support substrate and protruding toward the second support substrate, and a plurality of second protrusions disposed on the second support substrate and protruding toward the first support substrate.
12. The foldable display device according to item 11, wherein the plurality of first protrusions are disposed alternately with the plurality of second protrusions along a direction parallel to a folding axis of the foldable display device.

## Claims

1. A foldable display device (400, 500, 600, 700), comprising:
a display panel (110) including a folding area (FA) and non-folding areas (NFA, NFA1, NFA2) located on opposite sides of the folding area (FA);
a first support substrate (130) disposed under the display panel (110) and including a plurality of opening patterns (131) corresponding to the folding area (FA);
a second support substrate (140) disposed between the display panel (110) and the first support substrate (130); and
an adhesive layer (160) corresponding to the non-folding areas (NFA, NFA1, NFA2) and disposed between the first support substrate (130) and the second support substrate (140),
wherein at least one of the first support substrate (130) and the second support substrate (140) has different thicknesses at portions adjacent to a boundary between the folding area (FA) and at least one of the non-folding areas (NFA, NFA1, NFA2).

2. The foldable display device according to claim 1,
wherein the at least one of the first support substrate (130) and the second support substrate (140) includes a portion protruding toward the other one of the first support substrate (130) and the second support substrate (140) at a portion having the different thicknesses.

3. The foldable display device according to claim 2,
wherein the portion protruding toward the other one of the first support substrate (130) and the second support substrate (140) is disposed between the adhesive layer (160) and the folding area (FA).

4. The foldable display device according to claim 3,
wherein the adhesive layer (160) is disposed on a non-folding-area side of the portion protruding toward the other one of the first support substrate (130) and the second support substrate (140).

5. The foldable display device according to claim 3,
wherein the first support substrate (130) has a first thickness at an edge portion of one of the non-folding areas (NFA, NFA1, NFA2) adjacent to the folding area (FA) and a second thickness at a portion of the one of the non-folding areas (NFA, NFA1, NFA2) spaced apart from the folding area (FA), and
wherein the first thickness is greater than the second thickness.

6. The foldable display device according to claim 5,
wherein the portion protruding toward the second support substrate (140) comprises a protrusion (135, 137, 138) provided at the first support substrate (130).

7. The foldable display device according to claim 3,
wherein the second support substrate (140) has a first thickness at an edge portion of one of the non-folding areas (NFA, NFA1, NFA2) adjacent to the folding area (FA) and a second thickness at a portion of the one of the non-folding areas (NFA, NFA1, NFA2) spaced apart from the folding area (FA), and
wherein the first thickness is greater than the second thickness.

8. The foldable display device according to claim 7,
wherein the portion protruding toward the first support substrate (130) comprises a protrusion (245, 246) provided at the second support substrate (140).

9. The foldable display device according to claim 3,
wherein the first support substrate (130) includes a first protrusion (138) protruding toward the second support substrate (140), and
wherein the second support substrate (140) includes a second protrusion (246) protruding toward the first support substrate (130).

10. The foldable display device according to claim 9,
wherein the first protrusion (138) and the second protrusion (246) overlap each other in a thickness direction of the foldable display device.

11. The foldable display device according to claim 10,
wherein a gap is provided between the first protrusion (138) and the second protrusion (246).

12. The foldable display device according to claim 10,
wherein the first protrusion (138) and the second protrusion (246) contact each other.

13. The foldable display device according to claim 9,
wherein at least one of the first protrusion (138) and the second protrusion (246) includes a recess.

14. The foldable display device according to claim 13,
wherein the other one of the first protrusion (138) and the second protrusion (246) includes a sub-protrusion corresponding to the recess.

15. The foldable display device according to claim 1,
wherein portions of the first support substrate (130) disposed between adjacent opening patterns of the plurality of opening patterns (131) have different heights in the folding area (FA).
